(19) Europäisches Patentamt

European Patent Office

Office européen des brevets

(11) **EP 1 736 571 A1**

(12) **EUROPEAN PATENT APPLICATION**

(43) Date of publication:
27.12.2006 Bulletin 2006/52

(51) Int Cl.:
*C30B 23/02* (2006.01)    *C30B 29/54* (2006.01)
*C09K 19/00* (2006.01)    *C30B 7/02* (2006.01)

(21) Application number: 06252157.0

(22) Date of filing: 21.04.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 22.06.2005 JP 2005181766

(71) Applicant: NITTO DENKO CORPORATION
Ibaraki-shi,
Osaka 567-8680 (JP)

(72) Inventors:
• Khavrounyak, Igor V.
Moscow 125252 (RU)
• Lazarev, Pavel I.
London NW8 7LQ (GB)
• Lovetski, Konstantin P.
Moscow 125252 (RU)
• Paukshto, Mikhail V.
Foster City, California 94404 (US)

(74) Representative: Setna, Rohan P.
Boult Wade Tennant
Verulam Gardens
70 Gray's Inn Road
London WC1X 8BT (GB)

(54) **Method of manufacturing thin crystal films**

(57) The present invention provides a method configured to selectively optimize technology and composition of a liquid crystal system for the obtaining of thin crystal films (TCFs) possessing preset physical properties which are then used to manufacture thin crystal films.

Fig. 1

**Description**

FIELD OF THE INVENTION

The present invention relates to the field of molecular engineering aimed at obtaining molecularly ordered organic materials for various applications. The possible applications include display devices, optic-electronics, various optical elements, and the like.

BACKGROUND OF THE INVENTION

A special feature of the molecules of a number of organic dyes is the ability to form supramolecular liquid crystal mesophases. Containing peripheral functional groups, the mesophases of organic dyes are characterized by specific structures, phase diagrams, optical properties, and dissolving capabilities [J.-M. Lehn, Supramolecular Chemistry (New York, 1998)].

By using dichroic dyes capable of forming lyotropic liquid crystals, it is possible to obtain anisotropic films possessing a high degree of optical anisotropy. Such films exhibit the properties of E-type polarizers, which are related to peculiarities of the optical absorption of supramolecular complexes, and behave as retarders (phase-shifting devices) in the spectral regions where the optical absorption is insignificant The phase-retarding properties of these anisotropic films are related to their birefringence that is, to a difference in refractive indices measured in the direction of application of the liquid crystal solution onto a substrate and in the perpendicular direction. Films formed from the liquid crystal systems based on strong (light-fast) dye molecules are characterized by high thermal stability and light resistance. Such anisotropic crystalline films, referred to below as Thin Crystal Films (TCFs), can be obtained by a method developed by Optiva Technology and generally described in [P. Lazarev and M. Paukshto, Proceeding of the 7th International Workshop "Displays, Materials and Components" (Kobe, Japan, November 29-December 1, 2000, pp. 1159-1160) and in United States Published Patent Application No. US 2003/0154909, the disclosure of which is incorporated by reference in its entirety. This method is generally called the Cascade Crystallization Process and it is characterized by the sequence of steps involving various technological operations.

Selection of the base material for such a film is determined by the required optical and electrical properties. Other necessary conditions are the presence of a developed system of π-conjugated bonds in conjugated aromatic rings of the molecules and the presence of groups (such as amine, phenol, ketone, etc.) lying in the plane of the molecule and entering into the aromatic system of bonds. The molecules and/or their molecular fragments possess a planar structure and are capable of forming a stable lyotropic liquid crystal phase. Further description is found in United Sates Patent Nos. 5,739,296 and 6,174,394, which are incorporated herein by reference in their entirety.

When dissolved in an appropriate solvent, such an organic compound forms a colloidal system (lyotropic liquid crystal solution) in which molecules are aggregated into supramolecular complexes constituting kinetic units of the system. This liquid crystal phase is essentially a precursor of the ordered state of the system, from which a solid optically anisotropic crystal film (that is, TCF) is formed in the course of subsequent alignment of the supramolecular complexes and removal of the solvent In this film, the molecules are arranged so that their planes are parallel to each other and form a three-dimensional crystal, at least in a part of the layer. The film thickness usually does not exceed 1 μm. In order to obtain the films possessing desired optical and electrical characteristics, is it possible to use mixed colloidal systems capable of forming joint supramolecular complexes in solution. Upon removal of the solvent, such system forms a common three-dimensional crystal structure.

Various applications require the films possessing different optical and electrical properties. Being a multistage process, Cascade Crystallization depends on numerous technological parameters influencing the final properties of TCFs. Obtaining TCFs with preset properties requires optimization of these technological parameters. The present invention is aimed at solving this task.

SUMMARY OF THE INVENTION

The present invention provides a method configured to selectively optimize technology and composition of a liquid crystal system for the obtaining of TCFs possessing preset physical properties which are then used to manufacture thin crystal films. Preferably the Cascade Crystallization Process is used to manufacture the thin crystal films.

In one embodiment, the method of the present invention includes the steps of:

(a) producing a number of TCFs, wherein an initial mixture of organic compounds are the same for all films and the percentage composition of the mixture of organic compounds varies from film to film;
(b) measuring one or more physical characteristic for each of said films;
(c) choosing representation of said physical characteristics in the form of an approximating fimction of these physical characteristics as dependent on the percentages of organic compounds;

(d) determining extrema of the approximating function;

(e) testing stability of determined extrema and selecting one of these extrema; and

(f) manufacturing a TCF having a composition corresponding to the selected extremum for said physical characteristics.

In another aspect, the present invention provides TCFs, possessing preset physical properties, manufactured from standard, commercially available liquid crystal mixtures.

In another aspect of the present invention, a computer readable media containing a software program is provided that, when executed on a computer, carries out the instructions of:

measuring at least one physical characteristic of a number of thin crystal films produced by a Cascade Crystallization Process, the Cascade Crystallization Process parameters associated with technological operations;

choosing a representation of the physical characteristic in the form of an approximating function of the physical characteristic as dependent on the parameters of said technological operations;.

determining extrema of the approximating function;

testing stability of the determined extrema; and selecting one extemum of the extrema to be used in manufacture of said thin crystal film.

## BRIEF DESCRIPTION OF THE DRAWINGS

Objects and advantages of the present invention will become apparent upon reading the detailed description of the invention and the appended claims provided below, and upon reference to the drawings, in which:

Figure 1 shows a flowchart illustrating the method steps according to one embodiment of the present invention.

Figure 2 presents a block schematic diagram generally illustrating the Cascade Crystallization Process.

Figures 3-4 gives an example of the approximating function projected onto a simplex.

## DETAILED DESCRIPTION OF THE INVENTION

The present invention provides a method configured to selectively optimize technology and composition of a liquid crystal system for the obtaining of TCFs possessing preset physical properties which are then used in the Cascade Crystallization Process to manufacture thin crystal films

The Cascade Crystallization Process is characterized by the following sequence of main stages involving various technological operations:

(i) Formation of a colloidal system (liquid crystal solution);

(ii) Application of this system onto a substrate with simultaneous or subsequent external aligning action; and

(iii) Removal of the solvent and the formation of a TCF. This process is further described in detail in United States Patent Nos. 6,174,394 and 5,739,296 and in PCT Patent application no.PCT/US02/03800, published WO 02/063660, the disclosures of all are incorporated herein by reference in their entirety.

The TCFs made by this method exhibit the interplane spacing in a crystal in the range of approximately 3.1 Å to 3.7 Å along one of the optical axes. That is easily fixed with standard methods, such as for example X-ray diffraction. The Cascade Crystallization Process includes several interrelated technological operations, each influencing more or less significantly the quality of a TCF — the final product. The optimization procedure can be performed either with respect to most significant parameters of a separate technological operation or it may involve all parameters of the entire technological process. Selection of the optimization parameters depends on the required properties of TCFs.

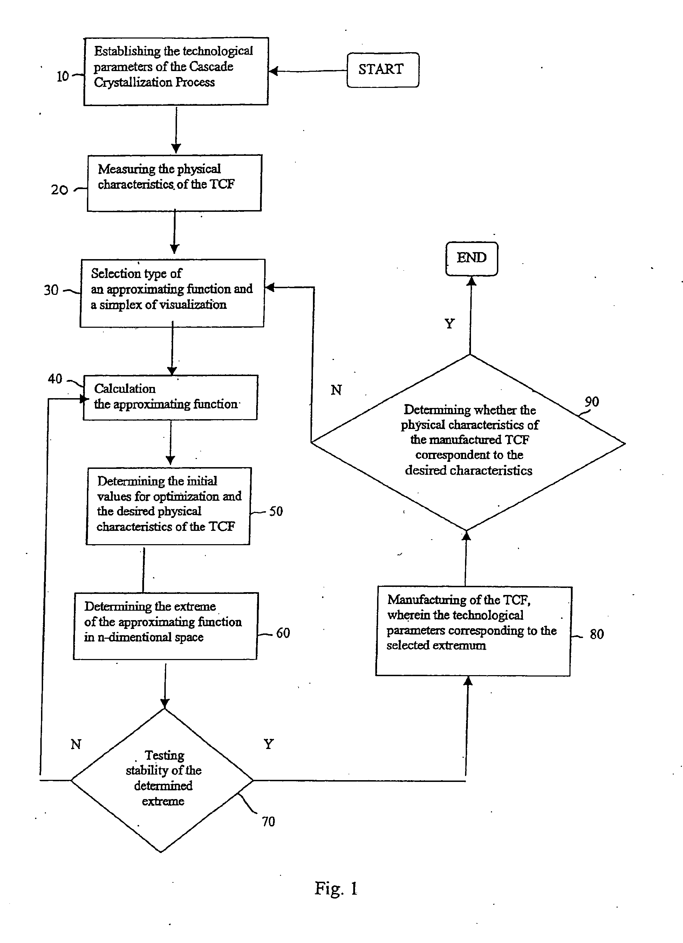

One embodiment of the method of the present invention is illustrated in the flowchart shown in Fig. 1. In general the method is carried out as follows: At step 10 technological parameters are established. Physical characteristics of the TCF are measured at step 20. Selection of the type of approximating function and simplex of visualization are performed at step 30. The approximating function is calculated at step 40. The initial values for optimization and the desired physical characteristics of the TCF are determined at step 50. Next the extreme of the approximating functions in n-dimensional space is determined at step 60. The stability of the determined extreme is the tested at step 70. If the determined extreme is not stable the method is executed again at step 40. If the determined extreme is stable, at step 80 the TCF is manufactured wherein the technological parameters correspond to the selected extremum. Finally, at step 90 it is determined whether the physical characteristics of the manufactured TCF corresponds to the desired characteristics. If yes, the method is ended. If no, the method is executed again at step 30.

The method of the present invention is now described in more detail. The disclosed method involves creating a data base containing measured physical characteristics of TCFs obtained by Cascade Crystallization Process and the corresponding technological parameters of the process, including characteristics of the initial liquid crystal system used for the TCF production. The parameters may vary within a certain working interval of parameters of technology operations. The number of measurements used to create the database has to be sufficient for subsequent approximations, and one of ordinary skill in the art will recognize that generally, the accuracy of the resulted characteristics of the manufactured film is of the order of, or is approximately equal to, the accuracy of the measured parameters of the technological operations.

The database can be complete (comprehensive), including all properties of the initial liquid crystal system, all parameters of each technological operation, and all required physical properties (selected physical characteristics) of TCFs. The properties of the initial liquid crystal system include composition, concentrations of components, types and concentrations of additives, etc. Selected physical characteristics of TCFs include optical (contrast, anisotropy coefficient, absorption spectrum. etc.), electrical (conductivity, anisotropy of conductivity, bandgap width, etc.), and magnetic.

On different steps of the Cascade Crystallization Process the following technological operations are characterized by the following parameters.

(i) On the step of formation of a colloidal system (liquid crystal solution): chemical composition of the liquid crystal system, component concentrations, temperature, additives, solvents, and the like;

(ii) On the step of application of this system onto a substrate: viscosity, application velocity, geometry of the application device, and the like;

(iii) On the step of subsequent external aligning action: amount and rate of mechanical shear (for the mechanical alignment), electric field strength and direction (for the electromagnetic alignment), and the like.;

(iv) On the step of solvent removal: drying speed, humidity and temperature of the medium, and the like.

This list is not intended to be a complete list of the parameters of the technological operations under review but it has shown the most typical examples of these parameters.

The database can be created as partial, that is, containing separate required characteristics of TCFs, some properties of the initial liquid crystal system (e.g., percentages of organic components), and/or most significant parameters of the technological process. Such a partial database can be used for the optimization of TCFs intended for particular applications such as polarizing films, birefringent films for displays, etc.

The database also includes a model represented by an approximating function reflecting the dependence of selected physical characteristics, $y^{(\mu)}$, on the parameters, $x^{(\mu)}$, for example, on the percentages of the organic compounds, some parameters of technological operations, etc. In the general case, the approximating fimction is a vector, since the optimization can be performed simultaneously with respect to several selected physical characteristics.

The approximation can be performed by various methods, in particular, using polynomial interpolation or radial basis functions (RBFs). The most attractive property of the RBF approximation procedure is the possibility of constructing the approximating function by linear methods. The RBF fitting points can be either preliminarily set (i.e., arranged on a regular grid) or determined in the course of data preparation (e.g., using clusterization procedures). In this situation, the variance is a quadratic function of unknown approximation parameters, which makes the numerical model less complicated and simplifies the calculation routine. There exist a point of global minimum that can be found by solving the problem of minimization of the variance by least squares or using some method of descent.

Thus, the approximation of experimental data is aimed at constructing a function

$$y^{(\mu)} = f(x^{(\mu)}), \qquad\qquad (1)$$

establishing a relationship within set P of input and output parameters (elements) $\left\{(x^{(\mu)}, y^{(\mu)})\right\}_{\mu=1}^{P}$. In practice, this unknown function $f(x)$ is approximated by a certain close function $\mathcal{\tilde f}(x)$, which is constructed using the available body of data. The interpolation condition (1) can be met either exactly or approximately, depending on the amount of data (set P) used to describe function $\mathcal{\tilde f}(x)$. In the latter case, the procedure is aimed at minimizing an error function representing, for example, the mean square deviation of an approximating function from the exact value:

$$\varepsilon_{mse} = \left\langle \left\| f(x) - \tilde{f}(x) \right\|^2 \right\rangle \tag{2}$$

A formula setting the radial basis vector functions is as follows,

$$\tilde{f}(\mathbf{x}) = \mathbf{w}_0 + \sum_{m=1}^{N_c} \mathbf{w}_m \phi(\|\mathbf{x} - \mathbf{c}_m\|), \tag{3}$$

where $\tilde{f}(x)$, $\mathbf{w}_m \in R^m$, x, $c_m \in R^n$, and W are the weighing coefficients of the function\ that are determined using the experimental data. Background description is further described in M.Kirby, Geometric Data Analysis (New York, 2001), which is incorporated herein by reference.

When the optimization is performed with respect to some selected physical characteristic of TCFs, the approximating function is scalar and condition (3) for each $\{(x^{(\mu)}, y^{(\mu)})\}_{\mu=1}^P$ acquires the following form:

$$\tilde{f}^\mu(x^\mu) = w_0 + \sum_{m=1}^{N_c} w_m \phi(\|x^\mu - c_m\|),$$

where $\mu = 1,..., P.$ Writing these conditions in the form of a system of linear equations, we obtain

$$\begin{pmatrix} f^{(1)} \\ f^{(2)} \\ \vdots \\ f^{(P)} \end{pmatrix} = \begin{pmatrix} 1 & \phi_1^{(1)} & \phi_2^{(1)} & \cdots & \phi_{N_c}^{(1)} \\ 1 & \phi_1^{(2)} & \phi_2^{(2)} & \cdots & \phi_{N_c}^{(2)} \\ & \vdots & & \ddots & \\ 1 & \phi_1^{(P)} & \phi_2^{(P)} & \cdots & \phi_{N_c}^{(P)} \end{pmatrix} \begin{pmatrix} w_0 \\ w_1 \\ \vdots \\ w_{N_c} \end{pmatrix},$$

where

$$\phi_j^{(i)} = \phi(\|\mathbf{x}^{(i)} - \mathbf{c}_j\|).$$

In a more compact writing,

$$\mathbf{f} = \Phi \mathbf{w}, \tag{4}$$

where $\Phi$ is the interpolation matrix defined as

$$(\Phi)_{ij} = \begin{cases} 1, & j = 1, \\ \phi_{j-1}^{(i)} & j > 1, \end{cases} \tag{5}$$

with vectors $w = (w_1, w_2,..., w_{N_C})^T$ and $f = (f^{(1)}, f^{(2)},..., f^{(P)})^T$.

The approximation with RBFs requires setting properties of the model, such as the RBF type and the number of these functions, specifying a set of fit points (centers) $\{c_m\}$ determining the positions of RHFs, and defining the weights

$\{w_m\}$. Each of these properties depends on the complexity and type of data modeled. Here, the main tasks are to determine the type of RBFs and their parameters, to define weights, and to select the fitting points (centers).

The approximation can be performed using RBFs of various types. Some of these are presented in Table 1.

Table 1

| $\phi(\xi)$ | Type | Local / global | Parameter |
|---|---|---|---|
| $\exp(-\xi^2/r^2)$ | Gaussian | local | r |
| $\xi$ | Linear | global | None |
| $\xi^3$ | Cubic | global | None |
| $\xi^2 \ln\xi$ | Thin plate spline | global | None |
| $(\xi^2+r^2)^{1/2}$ | Multiquadric | global | r |
| $(\xi^2 +r^2)^{-1/2}$ | Inverse multiquadric | local | r |

Selecting the RBF type presents rather a difficult task. The main problems are to choose a local or global function $\phi(\xi)$ and to select the free parameters. These parameters can be determined through nonlinear optimization or set arbitrarily.

It was experimentally established that a function most suited for the optimization of Cascade Crystallization Process is of the type:

$$\phi(\xi) = \exp\left(-\frac{\xi^2}{r^2}\right).$$

RBFs in this form provide for a local representation, their effective radius being determined by the parameter r that can be either in common for all RBFs or determined separately for each of these functions.

In the case of a Euclidean norm, the RBFs are expressed as

$$\phi\left(\left\|\mathbf{x}^{(\mu)} - \mathbf{c}_m\right\|\right) = \exp\left(-\frac{\sum_{k=1}^{n}(x_{k=1}^{(\mu)} - c_k^{(m)})^2}{r^2}\right).$$

Using the multiplicative property of the exponent, we can pass to the following form,

$$\phi\left(\left\|\mathbf{x}^{(\mu)} - \mathbf{c}_m\right\|\right) = \prod_{k=1}^{n}\exp\left(-\frac{\sum_{k=1}^{n}(x_{k=1}^{(\mu)} - c_k^{(m)})^2}{r^2}\right)$$

The Gaussian RBF is characterized by a limited "effective range" around the center of the function, which is proportional to the radius r. Outside this region of sensitivity, a contribution of each separate RBF to the total sum is small. This local character of the Gaussian RBF is a very useful property making the effect of each RBF localized in small vicinity around the center, not significantly influencing the presentation of data outside this region.

The problem of determining the weighing coefficients reduces to the problem of least squares for overdetermined systems of linear algebraic equations.

$$\mathbf{f} = \Phi\mathbf{w}. \qquad\qquad (6)$$

In the general case, this system either has no solutions or possesses the infinite number of solutions. It is a usual practice to find a normal solution of such a system of linear equations that minimizes the variance

$$E = \|\mathbf{f} - \Phi \mathbf{w}\|. \qquad (7)$$

The solution can be found by regularization of the procedure of obtaining a normal solution for unfaithfully known vector in the right-hand part.

Various methods are used for selecting the aforementioned centers (the RBF fitting points) in the space of measurements. Such points can be arranged on a regular grid, randomly distributed, or defined using clusterization algorithms or nonlinear optimization procedures.

After constructing the approximating function, the extrema of this function are determined in the space of measurements by means of a maximization procedure. The method of the present invention selectively determines and optimizes several parameters which are then used in the Cascade Crystallization Process by finding the points of extrema for each of the scalar approximating functions, after which the equilibrium point is determined according to Nash or Pareto. All extrema (or at least one selected) are analyzed with respect to stability. For this purpose, additional measurements of all physical characteristics are performed for the films obtained from the same liquid crystal system with admissible technological parameters. If the results of these measurements, being included into the data base, do not alter the position of a selected maximum of the approximating function, this maximum is considered as stable. If, however, the position of a selected maximum exhibits a change, several sequential iterations can be performed to calculate the modified approximating function and determine the refined extrema. Once the optimization procedure is terminated, subsequent fabrication of TCFs by Cascade Crystallization Process is carried out by processing appropriate liquid crystal systems using the technological parameters determined as described above.

In order to obtain TCFs possessing desired physical properties, it is necessary to use liquid crystal systems with properly selected compositions of select chemical compounds reproduced for all batches of TCFs.

Commercial batches of colloidal systems possess a standard composition of chemical compounds. In order to obtain the systems possessing optimum compositions in each particular case, it is necessary to mix the commercial colloidal systems in certain proportions. The mass or volume fractions of standard mixtures are usually determined empirically or calculated based on a certain model. Such a calculation is possible only provided that the process of mixing is additive, whereby there is no chemical or other interactions between components. Most of the liquid crystal systems used in the aforementioned applications exhibit additivity on mixing.

Natural limitations on the problem solutions are as follows:

- all components of the initial mixture must be contained in the standard systems;
- the fraction of any component has to fall within the interval (0,1);
- the sum of fractions of all components has to be unity.

According to the method of the present invention, we have developed an algorithm and wrote the corresponding software code for determining the fractions of standard additive systems to be mixed in order to obtain a mixture with desired composition. Given the method steps and teaching of the present invention, software can be written by those of ordinary skill to carry out the method.

If there are M standard systems including n components and we are seeking for an n-component mixture of a certain composition, the general equation can be written in the following form:

$$\begin{pmatrix} a_{11} \ldots a_{m1} \\ \ldots\ldots\ldots \\ a_{1n} \ldots a_{mn} \end{pmatrix} * \begin{pmatrix} x_1 \\ \ldots \\ x_m \end{pmatrix} = \begin{pmatrix} f_1 \\ \ldots \\ f_n \end{pmatrix},$$

where (a11, ..., am1) are the fractions of the corresponding components (xl, ..., xn) in the first standard mixture and so on, (f1, ..., fn) are the fractions of the corresponding components in the desired (optimum) mixture, and

$$\begin{pmatrix} a_{11} \dots a_{m1} \\ \dots\dots\dots\dots\dots \\ a_{1n} \dots a_{mn} \end{pmatrix} = A$$

is a stochastic matrix.

The greater the number of standard systems, the higher the possible quality of the desired final mixture. It is also necessary that the fractions of components in various standard systems would cover the entire interval (0, 1).

A solution to the above system of linear equations is obtained through minimization of $\|Ax\text{-}f\|$ (with optimization of $\|x\|$).

EXPERIMENTAL

The examples described below are presented for illustration purposes only, and are not intended to limit the scope of the present invention in any way.

Example 1. Optimization of TCF contrast

Supramolecular materials utilized in TCF manufacturing are based on watersoluble modified organic blue (B), violet (V), and red (R) dyes, which are the products of sulfonation of indanthrone and dibenzimidazole derivatives of perylenetetracarboxylic and naphthalenetetracarboxylic acids. Individual dyes, as well as their mixtures, can be used for the preparation of LLC materials. The samples of TCF polarizers for testing were produced by direct deposition of an LLC material onto poly(ethylene terephthalate) (PET) film.

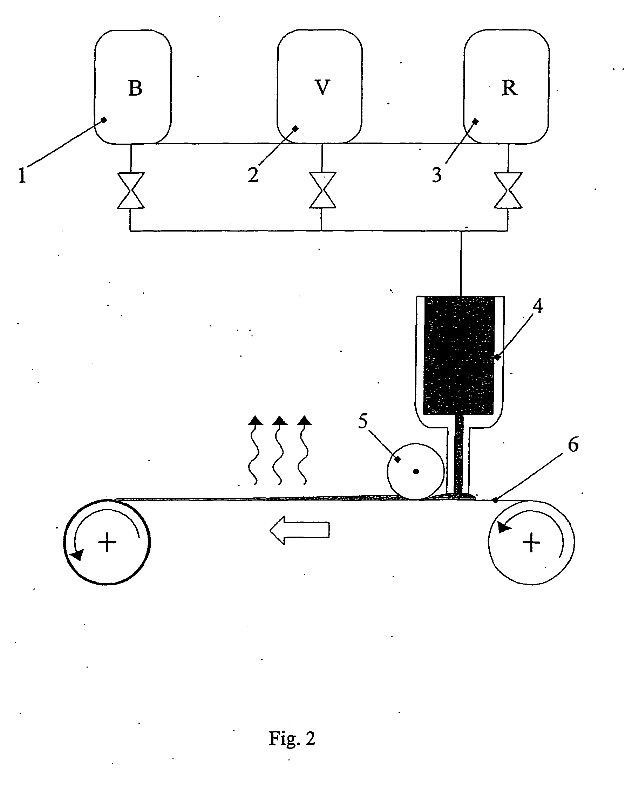

Various components (see Fig. 2) were delivered from containers 1, 2, and 3 to a mixer vessel 4, where a composition for TCF manufacturing was prepared. This mixture was supplied via a special channel to an application device. The coating was applied by means of a Mayer wire-wound rod 5, with the wire size depending on the thickness of a polarizer film required. The mixture was deposited onto PET film 6 using roll-to-roll process. A uniform wet coating 7-15 $\mu$m thick provides for the obtaining of 100 to 900 nm thick polarizers upon evaporation of aqueous solvent.

The measured optical and color characteristics of TCF polarizers are the optical transmission of samples oriented parallel and perpendicular to the polarization axes of the polarizer and analyzer (Tpar and Tper, respectively) and the color coordinates of the polarizer. The following parameters have been calculated:

(i) transmission of a single polarizer for an unpolarized light

$$T = \frac{Tpar + Tper}{2} \; ;$$

(ii) transmission of two parallel polarizers $\quad H_0 = \dfrac{Tpar^2 + Tper^2}{2} \; ;$

(iii) transmission of two crossed polarizers $H_{90} = Tpar \times Tper \; ;$

(iv) contrast ratio $\quad CR = \dfrac{H_0}{H_{90}} \; .$

The physical property of TCFs for optimization was the contrast ratio *(CR)*. The optimization parameters were the percentage contents of the modified organic blue dye components. This composition may contain di-, tri-, and tetrasulfoderivatives, trisulfochloride derivative, etc. (up to eleven components). Thus, we have optimized the *CR* function in the 11-dimensional space of percentage B-dye composition.

The initial data base contained the results of more than 400 measurements of the physical parameters of TCFs, in which the percentage composition of the mixture was varied from one film to another. The optimization procedure is based upon selection of the approximation function and its parameters, the initial point for the function section with a hyperplane, and the visualization simplex.

In the given case, the most appropriate approximation function is as follows:

$$\phi(\xi) = \exp\left(-\frac{\xi^2}{r^2}\right).$$

This function was constructed using the experimental data base mentioned above and the program package developed by the Optiva Inc. which carries out the method steps as described herein. The approximation function was visualized and the extrema of this function were determined for an intersection with a hyperplane. This was followed by graphical representation of the section as a surface on a simplex (representing a surface in the three-dimensional space). Coordinates of this simplex were the concentrations of di-, tri-, and tetrasulfoderivatives. The initial point for constructing a hyperplane was chosen in the vicinity of a point corresponding to the maximum experimental value of the physical parameter selected for optimization.

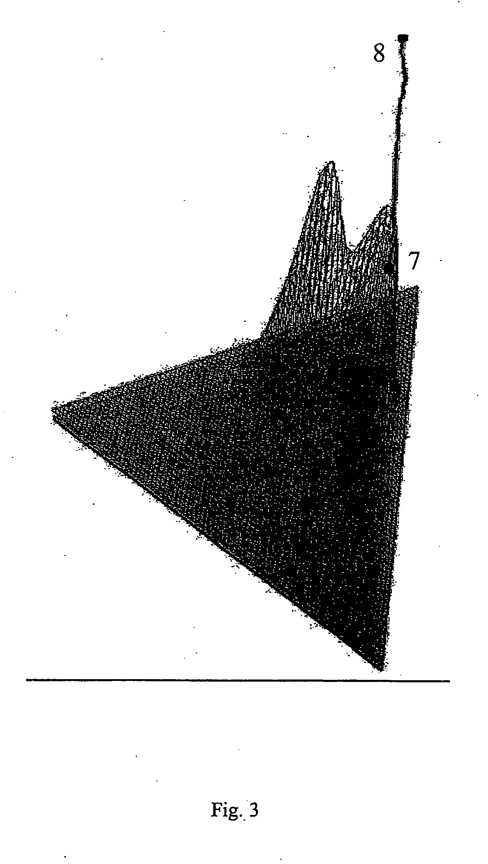

Figure 3 shows the resulting section of the function with a hyperplane at the point corresponding to a B-dye composition containing 10.7% tetra-sulfoderivative, 34.6% tri-sulfoderivative, and 22.5% di-sulfoderivative.

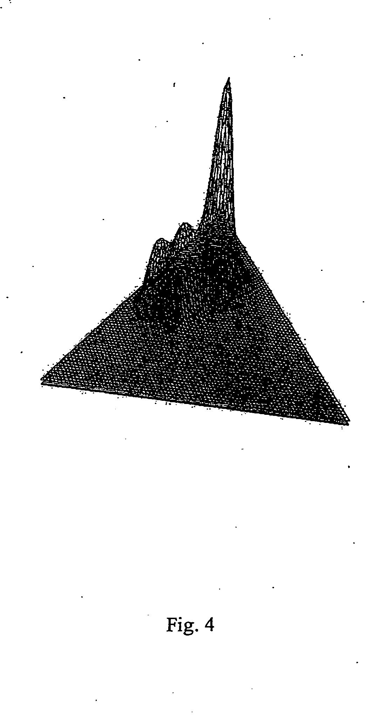

The initial conditions for determining the extremum of the approximation function in the n-dimensional space were represented by an arbitrary point 7 (Fig. 3) in the aforementioned three-dimensional surface. The optimization procedure yielded a point of maximum 8 that corresponded to an extremum of the initial approximation function. The next step in the proposed algorithm consists in the passage to a new section of the approximation function by a hyperplane at the point of maximum obtained in the preceding step. This section (representing a surface on the simplex) is depicted in Fig. 4.

In the case when the extrema determined in this way are stable (i.e., in dependent of the initial conditions), the optimization (maximization) procedure can be terminated. Should the extrema be unstable, additional iterations have to e performed.

In this example, point 8 corresponding to the maximum value of the contrast function CR has the following coordinates (percentage B-dye composition):

tetrasulfoderivative, 16,6%; trisulfoderivative, 39,1%; disulfoderivative, 13,8%; other components, 30,5%. The contrast ratio of a TCF with this composition, obtained by Cascade Crystallization Process, was CR =162 and this parameter was stably reproduced in all experiments.

## Claims

1. A method of manufacturing thin crystal film of at least one desired physical characteristic, the film is manufactured by Cascade Crystallization Process from a mixture of organic compounds, and the method comprising the steps of:

   (a) producing a number of thin crystal films by the Cascade Crystallization Process from mixtures of organic compounds,
   wherein the organic compounds in the mixture are the same for all said films and percentage composition of the mixture varies from the one produced film to another ;
   (b) measuring said at lest one physical characteristic for each of said produced films;
   (c) choosing a representation of said at least one physical characteristic in the form of an approximating function of said physical characteristic as dependent on the percentage composition of said mixture of organic compounds;
   (d) determining extrema of the approximating function;
   (e) testing stability of the determined extrema and selecting one extremum of said extrema and the corresponding composition of the mixture;
   (f) manufacturing the thin crystal film of the desired physical characteristic,

   wherein the composition corresponding to the selected extremum is used for the mixture of organic compounds for the manufacturing of the film of said physical characteristic.

2. The method according to Claim 1, wherein the steps (a) through (e) are repeated more than one time before the step of the film manufacturing.

3. The method according to Claim 1, wherein the Cascade Crystallization Process comprises technological operations of application of a film of lyotropic liquid crystal, external alignment action upon the lyotropic liquid crystal film, and removal of a solvent, and wherein each said technological operation has at least one characteristic parameter.

4. The method according to Claim 3, wherein at least one of the characteristic parameters of said technological operations varies from the one produced film to another, and representation is made in the form of approximating function of at least one of the physical characteristics as dependent on the percentages of the mixture of organic compounds and the parameters of technological operations.

5. The method according to Claim 4, wherein the characteristic parameters of said technological operations are selected from the group consisting of chemical composition of lyotropic liquid crystal, its concentration, temperature, and viscosity; velocity of the lyotropic liquid crystal application, intensity and direction of the external alignment action and speed of the solvent removal.

6. The method according to Claim 3, wherein lyotropic liquid crystal is formed by rodlike supramolecules composed of the molecules of the organic compounds.

7. The method according to Claim 6, wherein the rodlike supramolecules have an intermolecular spacing of $3.4 \pm 0.3$ Å in the direction of one of main optical axes.

8. The method according to Claim 1, wherein at least one of said organic compounds is a polycyclic organic compound with conjugated $\pi$-system of bonds.

9. The method according to Claim 8, wherein said polycyclic organic compound contains heterocycles.

10. The method of claim 1 wherein the approximating function is comprised of polynomial interpolation or radial basis functions.

11. A method of manufacturing thin crystal film of at least one desired physical characteristics, the thin crystal film is manufactured by Cascade Crystallization Process from a mixture of organic compounds, wherein the Cascade Crystallization Process comprises technological operations of application of a film of a lyotropic liquid crystal, external alignment action upon the lyotropic liquid crystal film, and removal of a solvent, and wherein each technological operation has at least one parameter, the method comprising the steps of:

   (a) producing a number of thin crystal films by said Cascade Crystallization Process, wherein the mixture of organic compounds is the same for all produced films and the parameters of said technological operations vary from one produced film to another;
   (b) measuring said physical characteristic for each of said films;
   (c) choosing of a representation of said physical characteristics in the form of an approximating function of said physical characteristics as dependent on the parameters of said technological operations;
   (d) determining extrema of the approximating function;
   (e) testing stability of the determined extrema and selecting one extremum of said extrema; and
   (f) manufacturing of the thin crystal film of the desired physical characteristic by using selected parameters of the technological operations corresponding to the selected extremum for said physical characteristics.

12. A method of selecting a mixture of organic compounds having specific parameters that will produce a thin crystal film having one or more desired physical characteristics, comprising the steps of:

   (a) producing a number of thin crystal films by said Cascade Crystallization Process, wherein the mixture of organic compounds is the same for all produced films and the parameters vary from one produced film to another;
   (b) measuring said physical characteristic for each of said films;
   (c) choosing a representation of said physical characteristics in the form of an approximating function of said physical characteristics as dependent on the parameters ;
   (d) determining extrema of the approximating function;
   (e) testing stability of the determined extrema and
   (f) selecting one extremum of said extrema, the selected extremum corresponding to the specific parameters that will produce a thin crystal film of desired physical characteristic.

13. A computer readable media containing a software program that, when executed on a computer, carries out the instructions of:

measuring at least one physical characteristic of a number of thin crystal films produced by a Cascade Crystallization Process, the Cascade Crystallization Process parameters associated with technological operations; choosing a representation of said physical characteristic in the form of an approximating function of said physical characteristic as dependent on the parameters of said technological operations; determining extrema of the approximating function; testing stability of the determined extrema; and selecting one extemum of said extrema to be used in manufacture of said thin crystal film.

Fig. 1

Fig. 2

Fig. 3

Fig. 4

**European Patent Office**

**EUROPEAN SEARCH REPORT**

Application Number

EP 06 25 2157

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| P,X | US 2005/146671 A1 (KHAVROUNYAK IGOR V [RU] ET AL) 7 July 2005 (2005-07-07) * the whole document * | 1-13 | INV. C30B23/02 C30B29/54 C09K19/00 C30B7/02 |
| X | WO 02/063660 A (OPTIVA INC [US]; LAZAREV PAVEL [US]; NAZAROV VICTOR [RU]; OVCHINNIKOVA) 15 August 2002 (2002-08-15) * page 5, line 21 - page 11, line 24; claims 1-72 * | 1-13 | |
| X | NAZAROV V ET AL: "ELECTRONIC SPECTRA OF AQUEOUS SOLUTIONS AND FILMS MADE OF LIQUID CRYSTAL INK FOR THIN FILM POLARIZERS" MOLECULAR MATERIALS (ONLINE), GORDON AND BREACH, LAUSANNE, CH, vol. 14, 2001, pages 153-163, XP008034689 ISSN: 1563-5295 * the whole document * | 1-13 | |
| X | IGNATOV L ET AL: "MOLECULAR ALIGNMENT IN NANO-FILM CRYSTAL POLARIZERS AND RETARDERS" PROCEEDINGS OF THE SPIE, SPIE, BELLINGHAM, VA, US, vol. 4807, 7 July 2002 (2002-07-07), pages 177-188, XP001202104 ISSN: 0277-786X * the whole document * | 1-13 | TECHNICAL FIELDS SEARCHED (IPC) C30B C09K |

The present search report has been drawn up for all claims

| Place of search | Date of completion of the search | Examiner |
|---|---|---|
| The Hague | 17 November 2006 | Lavéant, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 25 2157

This annex lists the patent family members relating to the patent documents cited in the above-mentioned European search report.
The members are as contained in the European Patent Office EDP file on
The European Patent Office is in no way liable for these particulars which are merely given for the purpose of information.

17-11-2006

| Patent document cited in search report | Publication date | Patent family member(s) | | Publication date |
|---|---|---|---|---|
| US 2005146671 A1 | 07-07-2005 | NONE | | |
| WO 02063660 A | 15-08-2002 | CN | 1460282 A | 03-12-2003 |
| | | EP | 1358667 A1 | 05-11-2003 |
| | | JP | 2004519014 T | 24-06-2004 |
| | | US | 2003154909 A1 | 21-08-2003 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030154909 A
- US 5739296 A
- US 6174394 B
- US 0203800 A
- WO 02063660 A

**Non-patent literature cited in the description**

- **J.-M. LEHN.** *Supramolecular Chemistry,* 1998
- **P. LAZAREV ; M. PAUKSHTO.** Displays, Materials and Components. *Proceeding of the 7th International Workshop,* 29 November 2000, 1159-1160